(19) Europäisches Patentamt / European Patent Office / Office européen des brevets

(11) **EP 2 489 142 B1**

(12) **FASCICULE DE BREVET EUROPEEN**

(45) Date de publication et mention de la délivrance du brevet:
**12.12.2018 Bulletin 2018/50**

(21) Numéro de dépôt: **10768460.7**

(22) Date de dépôt: **12.10.2010**

(51) Int Cl.:
*H04J 3/06* (2006.01)    *H03L 7/00* (2006.01)
*H04W 56/00* (2009.01)

(86) Numéro de dépôt international:
**PCT/EP2010/065249**

(87) Numéro de publication internationale:
**WO 2011/045300 (21.04.2011 Gazette 2011/16)**

(54) **DISPOSITIF DE COMMUNICATION IP ET RADIO SYNCHRONISÉ PAR UN SEUL OSCILLATEUR ET PROCEDE DE CONTROLE DE L'OSCILLATEUR**

DURCH EINEN EINZELNEN OSZILLATOR SYNCHRONISIERTE RADIO UND IP KOMMUNIKATIONSVORRICHTUNG SOWIE VERFAHREN ZUR OSZILLATORREGELUNG

RADIO AND IP COMMUNICATION DEVICE SYNCHRONIZED BY A SINGLE OSCILLATOR AND OSCILLATOR CONTROL METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.10.2009 FR 0957230**

(43) Date de publication de la demande:
**22.08.2012 Bulletin 2012/34**

(73) Titulaire: **SAGEMCOM BROADBAND SAS 92500 Rueil Malmaison (FR)**

(72) Inventeurs:
• **JOURDAIN, Laurent**
 **F-92500 Rueil Malmaison (FR)**
• **DONNENWIRTH, Freddy**
 **F-92500 Rueil Malmaison (FR)**
• **GEHENIAU, Frédéric**
 **F-92500 Rueil Malmaison (FR)**

(74) Mandataire: **Cabinet Le Guen Maillet 3, impasse de la Vigie CS 71840 35418 Saint-Malo Cedex (FR)**

(56) Documents cités:
**EP-A1- 1 835 616      WO-A1-2006/110960**
**US-B2- 6 898 721**

• **"Clock solutions for WiFi (IEEE 802.11)", , 9 mai 2003 (2003-05-09), pages 1-4, XP002587115, Extrait de l'Internet: URL:http://www.pericom.com/pdf/applications/AN070.pdf [extrait le 2010-06-11]**

**Description**

La présente invention concerne le domaine des dispositifs de communication par radio et plus particulièrement des passerelles connectées d'une part à un réseau de communication radio cellulaire à travers un réseau de communication de données par paquets tel qu'un réseau *IP* (*Internet Protocol* en anglais défini dans la RFC 791) et d'autre part à des terminaux de communication mobile cellulaire. Les stations de base de téléphonie mobile cellulaire sont un exemple de telles passerelles.

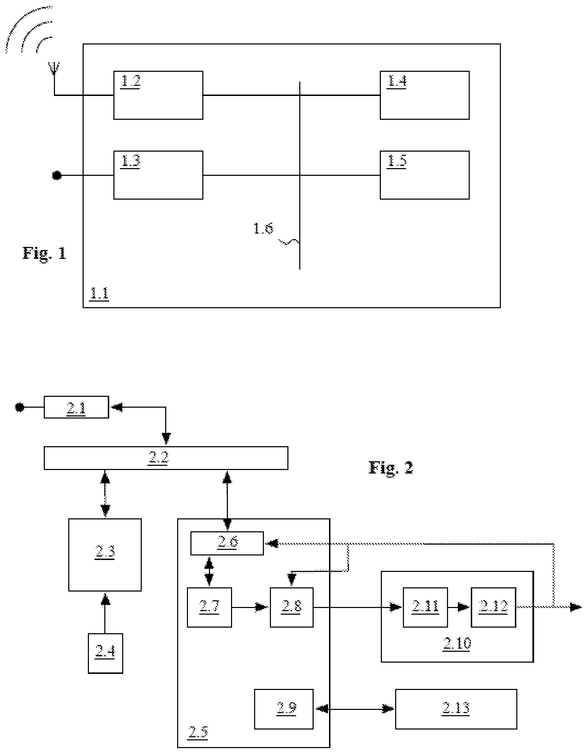

L'architecture générale de telles passerelles est illustrée schématiquement Fig. 1. La passerelle 1.1 comprend un module radio 1.2 qui gère les communications radio. Elle comprend également une interface réseau 1.3, par exemple une interface Ethernet selon la norme internationale : *ISO/IEC 8802-3.* Le fonctionnement de la passerelle s'effectue sous le contrôle d'un processeur général 1.4 à l'aide de programmes stockés dans une mémoire 1.5. Ces différents modules communiquent à l'aide d'un bus de données 1.6.

Nous nous intéressons plus particulièrement à la génération des horloges nécessaires au fonctionnement de ces passerelles. D'une part, le processeur nécessite une horloge de référence pour son fonctionnement. Cette horloge est typiquement dans le domaine de fréquence de quelques dizaines de Mhertz. Une légère dérive de cette horloge n'est généralement pas pénalisante.

D'autre part, le module de communication radio nécessite une horloge de référence de l'ordre de 20MHz, cette fréquence étant ensuite multipliée pour obtenir la fréquence radio. Cette horloge doit être très précise. Les dérives tolérables sont ici très faibles. Par exemple, les passerelles fonctionnant selon la norme de troisième génération HSPA (*High Speed Packet Access* en anglais) fonctionne à une fréquence radio de l'ordre de 2giga-hertz et doivent respecter une dérive inférieure à 250 ppb (*Part Per Billion* en anglais) pour le système complet. Pour garantir ceci, l'horloge doit également respecter une dérive inférieure à 250 ppb.

Pour pouvoir respecter cette contrainte forte sur la dérive de l'horloge nécessaire au sous-système radio, cette horloge doit être synchronisée à l'aide d'une horloge externe. Les solutions connues utilisent typiquement un module de réception GPS (*Global Positioning System* en anglais), le signal GPS contenant une horloge très précise ou encore une interface de télécommunication synchrone permettant le branchement d'une horloge de référence externe. Ces solutions sont envisageables pour du matériel professionnel tel que les stations de base d'un réseau téléphonique cellulaire. Elles se révèlent par contre coûteuses et peu adaptées pour des stations de base grand public destinées à être implantées au domicile des utilisateurs connectées à leur réseau local.

Dans le contexte d'appareils grand public, il est tentant d'utiliser la connexion existante au réseau de données par paquets pour se connecter à des horloges externes permettant la synchronisation de l'horloge de référence du sous-système radio. On peut, par exemple, utiliser une connexion à des horloges de référence disponibles au travers du réseau Internet à l'aide du protocole NTP (*Network Time Protocol* en anglais défini par la RFC 1305) ou encore le protocole PTP (*Precision Time Protocol* en anglais) normalisé par l'IEEE sous la référence IEEE 1588 et standardisé sous la référence IEC 61588. Les appareils fonctionnant sous ce principe sont typiquement gérés par un processeur alimenté par une horloge de référence locale. L'horloge de référence du sous-système radio est alors générée par un oscillateur dédié. Cet oscillateur est contrôlé par un composant matériel dédié. Ce composant matériel gère le protocole de synchronisation, par exemple NTP, et contrôle l'oscillateur pour en limiter la dérive et la maintenir dans la tolérance acceptable.

La demande EP 1835 616 (Mitsubishi) divulgue une station de base sans-fil connectée à un réseau filaire (tel qu'Ethernet) au travers duquel elle obtient une information temporelle de référence fournie par un serveur, comme par exemple un serveur NTP. La station de base sans-fil comprend une unité d'oscillation contrôlée en tension, VCO, et une unité de génération d'information temporelle à partir du signal d'horloge généré par le VCO. La station de base sans-fil comprend en outre une unité de comparaison d'informations temporelles qui compare l'information temporelle fournie par l'unité de génération d'information temporelle et l'information temporelle de référence. Le signal d'horloge issu du VCO est alors ajusté en fonction de la comparaison des informations temporelles.

Le brevet US 6898721 (Schmidt) divulgue un dispositif de communication sans-fil d'un coeur; radio cellulaire, d'un émetteur/récepteur sans fil et d'un coeur processeur reconfigurable. Le coeur processeur reconfigurable peut comprendre un ou plusieurs processeurs et/ou un ou plusieurs DSP. Les coeurs reçoivent un même signal d'horloge de référence commune fourni par un contrôleur d'horloge, comprenant un oscillateur VCO, qui peut être externe ou embarqué dans le composant.

L'invention vise à proposer une solution permettant de réduire encore le coût et de gagner en simplicité dans la conception de telles passerelles. Pour ce faire, elle propose d'utiliser le même oscillateur pour fournir d'une part l'horloge de référence du sous-système radio, mais également pour fournir l'horloge de référence du processeur général du dispositif Le fait d'utiliser un même oscillateur pour ces deux composants permet en outre de proposer des modes de réalisation où certaines des fonctions jusqu'alors dévolues à un composant de contrôle matériel fonctionnant lui-même à l'aide d'une horloge dérivée de l'oscillateur radio et intervenant dans le contrôle de cet oscillateur peuvent être maintenant dévolues à un composant logiciel exécuté sur le processeur général de la passerelle.

L'invention concerne un dispositif de communication comprenant une interface de communication avec un réseau de communication par paquets ; un processeur général ; un sous système de radio communication ; un oscillateur pour la génération du signal d'horloge de référence du sous-système de radio communication ; des moyens de synchronisation pour synchroniser le signal d'horloge de référence du sous-système de radio communication avec au moins une source de référence distante au travers du réseau de communication par paquets et des moyens de générer l'horloge de référence du processeur général et l'horloge de référence du sous-système radio à partir du même oscillateur.

Selon un mode particulier de réalisation de l'invention, les moyens de synchronisation comprennent des moyens logiciels d'horodatage de paquets de données échangés entre le dispositif et la source de référence distante exécutés par le processeur général.

Selon un mode particulier de réalisation de l'invention, les moyens de synchronisation comprennent des moyens de contrôle de la fréquence de l'oscillateur.

Selon un mode particulier de réalisation de l'invention, le dispositif comprend en outre des moyens logiciels pour maintenir l'oscillateur à température constante à l'aide d'un radiateur.

Selon un mode particulier de réalisation de l'invention, les moyens de contrôle de la fréquence de l'oscillateur comprennent un protocole de synchronisation temporelle qui génère des échantillons de deux valeurs, une première relative à la stabilité de l'horloge et une seconde relative à la dérive de fréquence et un algorithme de contrôle de l'oscillateur pour générer une valeur de tension à partir des échantillons issus du protocole de synchronisation temporelle.

Selon un mode particulier de réalisation de l'invention, le processeur central disposant d'un convertisseur PWM, l'algorithme de contrôle de l'oscillateur dispose de moyens de génération d'un signal PWM à l'aide de ce convertisseur à partir de la valeur de tension ; le dispositif comprenant en outre un circuit qui convertit ce signal PWM en un signal de tension appliqué à l'oscillateur mis en forme et filtré avec une précision et stabilité suffisante pour assurer la précision finale de la fréquence du système.

Selon un mode particulier de réalisation de l'invention, ledit circuit est composé :

- d'un calibrateur de tension recevant le signal PWM ;
- d'un filtre passe-bas du second ordre filtrant la sortie du calibrateur de tension ;
- d'un amplificateur opérationnel monté en suiveur et intercalé entre la sortie du filtre passe-bas du second ordre et ledit oscillateur.

Ainsi, il est possible de choisir des composants standards, à faible coût, pour réaliser la fonction de contrôle de l'oscillateur.

Selon un mode particulier de réalisation de l'invention, une porte logique est intercalée entre le convertisseur PWM et le calibrateur de tension 9.2, et est adaptée pour réduire les temps de transition du signal PWM.

Ainsi, la précision de la valeur de tension de contrôle de l'oscillateur est accrue.

Selon un mode particulier de réalisation de l'invention, l'algorithme de contrôle de l'oscillateur comprend : des moyens de réception des échantillons issus du protocole de synchronisation ; des moyens de qualification pour éliminer les échantillons dont la stabilité est insuffisante ; des moyens de tri pour trier les échantillons qualifiés par leur valeur de dérive et éliminer les échantillons de plus petite et plus grande dérive ; des moyens de calcul de la moyenne de la dérive des échantillons restants et des moyens de calcul de la tension à partir de la moyenne.

L'invention concerne également un procédé de contrôle d'un oscillateur selon la revendication indépendante 10.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

La Fig. 1 illustre l'architecture générale de passerelles selon l'art antérieur ;
La Fig. 2 illustre un exemple d'architecture de manière classique;
La Fig. 3 illustre le mode de réalisation préféré de l'invention ;
La Fig. 4 illustre le fonctionnement d'un processus classique de synchronisation d'horloge ;
La Fig. 5 illustre le fonctionnement de la synchronisation selon un mode de réalisation de l'invention ;
La Fig. 6 illustre la génération des étiquettes temporelles dans le cas où une unité matérielle d'horodatage des paquets est utilisée ;
La Fig. 7 illustre la gestion des étiquettes temporelles selon un mode de réalisation de l'invention ;
La Fig. 8 illustre le procédé de contrôle de l'oscillateur selon un mode de réalisation de l'invention ;
La Fig. 9 illustre schématiquement un mécanisme de contrôle en tension de l'oscillateur selon un mode de réalisation de l'invention.
La Fig. 10 illustre schématiquement un mode de réalisation d'un calibrateur et d'un filtre passe-bas du second ordre, dans un mode de réalisation de l'invention.

Le fonctionnement d'une passerelle basée sur des domaines d'horloge séparés pour le processeur général et pour le sous-système radio est décrit plus en détail.

La Fig. 2 illustre un exemple d'une telle architecture pour une passerelle utilisant un tel protocole pour la synchronisation de son horloge de référence du sous-système radio. La passerelle est reliée à un réseau de communication de données par une interface physique Ethernet 2.1. Le trafic Ethernet est dirigé vers un répartiteur Ethernet 2.2. La fonction de ce répartiteur est de séparer les paquets liés au protocole de synchronisation d'horloge, par exemple NTP, des autres paquets liés aux échanges réseau de la passerelle et gérés par la pile de protocoles de communication implantée dans le système d'exécution de la passerelle. Cette pile de protocoles est exécutée sur le processeur 2.3. Pour son fonctionnement, ce processeur reçoit un signal d'horloge de référence issu d'un oscillateur local 2.4 de manière classique.

La passerelle contient également un composant 2.5 de contrôle d'un oscillateur générant l'horloge de référence du sous-système radio. Cet oscillateur 2.10 comprend l'oscillateur proprement dit 2.12, typiquement un oscillateur contrôlé en tension ou VCXO (*Voltage Controlled Oscillator* en anglais). La tension de contrôle est issue du convertisseur numérique analogique 2.11 qui convertit un signal de tension numérique reçu du composant de contrôle 2.5.

Le composant de contrôle 2.5 maintient un compteur d'étiquettes temporelles (*timestamp* en anglais) 2.6 qui, lui, sert à horodater les paquets du protocole NTP qu'il échange avec le répartiteur Ethernet 2.2. Ce compteur fonctionne grâce à un signal d'horloge issu de l'oscillateur 2.10. La valeur de ce compteur d'étiquettes temporelles 2.6 est utilisée par un module de gestion du protocole de synchronisation de temps 2.7. C'est ce module de gestion qui génère le signal de correction de fréquence qu'il passe à un module 2.8 de contrôle de fréquence. Ce dernier génère alors en fonction de ce signal de correction de fréquence le signal de contrôle de fréquence, en l'occurrence une valeur de tension numérique, envoyé à l'oscillateur 2.10.

Le composant de contrôle 2.5 contient également un module 2.9 de gestion de la température de l'oscillateur 2.10. Ce module contrôle un module de chauffage 2.13 pour maintenir l'oscillateur à une température constante favorisant sa stabilité.

Nous ne rentrons pas ici dans la description exacte du protocole NTP permettant de synchroniser l'oscillateur. Ce protocole est décrit dans la RFC 1305 et son utilisation pour contrôler un oscillateur est connue. Le composant de contrôle 2.5 est un composant connu disponible dans le commerce, par exemple les composants SEMTECH de la famille ToPSync™ fournissent une solution de synchronisation sur PTP, d'autres réalisations en FPGA offrent des solutions de synchronisation sur NTP.

Il est à noter que le fonctionnement de cette architecture est basé sur le fait que le compteur 2.6 qui sert à l'horodatage des paquets NTP et au module 2.7 de gestion du protocole de synchronisation temporelle fonctionne à une cadence générée par un signal d'horloge issue de l'oscillateur 2.10 que l'on cherche à synchroniser.

L'invention est basée sur une simplification de cette architecture visant à n'utiliser qu'un seul oscillateur tant pour le sous-système radio que pour le processeur général de la passerelle et l'interface réseau. L'utilisation d'une seule source d'horloge pour l'intégralité du système permet en outre plusieurs améliorations optionnelles supplémentaires. Avantageusement, l'horloge du processeur principal peut être dérivée de l'oscillateur utilisé par le sous-système radio. Avantageusement, le compteur d'étiquettes temporelles matériel utilisé dans l'art antérieur peut être remplacé par un compteur logiciel sur le processeur principal. Toutes les fonctions temporelles numériques utilisées notamment par le protocole NTP, y compris l'horodatage des paquets, généralement exécutées par un composant matériel annexe peuvent être prises en charge par le processeur général. Il est donc possible de réaliser la passerelle sans utiliser de composant spécifique.

Un mode de réalisation minimum de l'invention consiste à remplacer le module de génération de l'horloge 2.4 de la Fig. 2 alimentant le processeur principal par un signal d'horloge dérivé de l'oscillateur 2.10. Ce mode de réalisation permet déjà une simplification de l'architecture et une diminution du coût de fabrication. Toutefois, il est possible d'améliorer encore la solution en déportant sur le processeur principal tout ou partie des fonctions réalisées par des composants matériels dans le mode de réalisation de la Fig. 2.

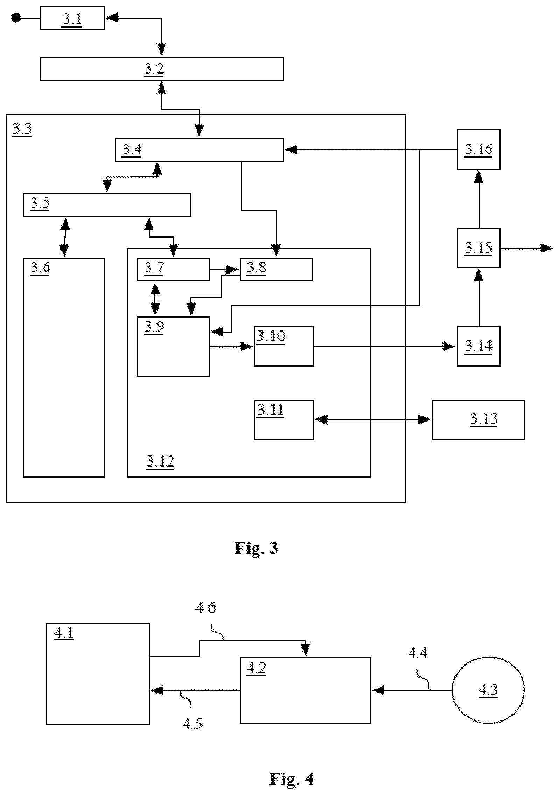

La Fig. 3 illustre le mode de réalisation préféré de l'invention. Sur cette figure on retrouve l'interface physique Ethernet 3.1 connectée à un module de contrôle d'accès au support 3.2 ou Ethernet MAC (*Medium Access Control* en anglais). Le module 3.3 représente le logiciel s'exécutant sur le processeur général de la passerelle. Le trafic réseau Ethernet passe par une unité de gestion des étiquettes temporelles 3.4. Cette unité effectue la transmission des trames Ethernet entre le matériel et les couches logicielles supérieures. Elle comprend un compteur temporel logiciel qui permet l'horodatage des moments de réception et d'émission des trames Ethernet. Elle mémorise dans un registre ces moments de transmission des trames. Ces informations sont ensuite utilisées par le client de gestion temporelle.

Les trames Ethernet sont ensuite remontées à la pile de protocoles IP 3.5. Les trames non relatives au protocole de gestion temporelle sont alors disponibles pour l'applicatif de gestion de la passerelle 3.6.

Le module de gestion temporelle 3.12 échange des trames Ethernet dédiées au protocole de gestion du temps, NTP, PTP ou autre, avec la pile IP 3.5 au travers de l'interface 3.7. Ces échanges ont lieu tant en émission qu'en réception. Les trames émises recevront une étiquette temporelle de leur moment d'émission par l'unité de gestion des étiquettes temporelles 3.4. Ces étiquettes permettant de connaître les moments d'émission des trames sont remontées par l'unité de gestion 3.4 au module 3.12 via l'interface d'étiquette temporelle ou *Time Stamp Interface* en anglais 3.8. Les trames reçues par l'interface 3.7 sont horodatées. De cette façon, le protocole de synchronisation temporelle 3.9 possède la connaissance des moments d'émission et des moments de réception de toutes les trames Ethernet liées au protocole NTP. Ce protocole de synchronisation temporelle 3.9 est alors à même de maintenir l'heure exacte courante à l'aide de ces étiquettes temporelles.

Le protocole de synchronisation temporelle 3.9 qui reçoit le signal d'horloge issu de l'oscillateur peut alors calculer sa dérive et envoyer cette dérive à un algorithme 3.10 de contrôle de l'oscillateur. Cet algorithme implémente le contrôle de la fréquence. Il utilise l'information produite par le protocole de synchronisation temporelle 3.9 et génère un mot de contrôle de 16 bits pour contrôler l'oscillateur local. Ce mot de contrôle est alors envoyé à un circuit 3.14 qui le convertit en un signal de tension appliqué à l'oscillateur 3.15 commandé en tension. Alternativement, lorsque le processeur central dispose d'un convertisseur PWM (*Pulse Width Modulation* en anglais), le mot de contrôle généré par le protocole de synchronisation temporelle 3.9 est converti en un signal PWM qui est envoyé au circuit 3.14. Cette conversion se fait avec une précision et stabilité suffisantes pour assurer la précision finale de la fréquence du système. L'oscillateur 3.15 génère le signal de sortie qui sera utilisé par le sous-système radio. Ce signal de sortie est également utilisé par un synthétiseur d'horloge 3.16. Ce synthétiseur est typiquement une boucle à phase asservie ou PLL (*Phase-Locked Loop* en anglais). Cette horloge est utilisée comme horloge de référence du processeur général et est envoyée à l'unité de gestion des étiquettes temporelles 3.4 où elle sert à cadencer le compteur temporel ce qui permet une gestion logicielle des étiquettes temporelles. Elle est également envoyée vers l'interface physique Ethernet 3.1 ainsi qu'au protocole de synchronisation temporelle 3.9 qui va en déduire sa dérive.

Avantageusement, le module 3.12 contient également un algorithme de gestion de température 3.11 pour maintenir l'oscillateur 3.15 à température constante à l'aide du radiateur 3.13.

Avantageusement, il contient également un contrôleur de haut niveau permettant une calibration en usine de l'oscillateur pour accélérer la convergence sur site de la synchronisation. Ce contrôleur peut également contenir des moyens d'adapter les algorithmes utilisés à différents oscillateurs ayant des caractéristiques variables. Il peut également permettre de gérer des statuts, statistiques, alarmes et évènements au sein du module de gestion temporelle 3.12.

Nous allons maintenant détailler le fonctionnement du processus de synchronisation utilisé dans l'invention.

Le fonctionnement d'un processus classique de synchronisation d'horloge est décrit par la Fig. 4. Selon cette figure, un oscillateur 4.3 émet un signal d'horloge à une fréquence propre locale. Cette fréquence propre 4.4 est reçue par un synthétiseur d'horloge 4.2 qui la divise par une valeur mémorisée pour générer l'horloge ajustée 4.5. C'est cette horloge ajustée 4.5 qui est alors corrigée pour compenser les différences avec une horloge de référence par le protocole de synchronisation temporelle 4.1. Cette compensation se fait par ajustement 4.6 de la valeur mémorisée utilisée pour diviser la fréquence propre de l'oscillateur par le synthétiseur d'horloge 4.2. On constate que selon cette manière de faire, la synchronisation d'horloge se fait par ajustement de la synthèse d'horloge sans intervention sur l'oscillateur.

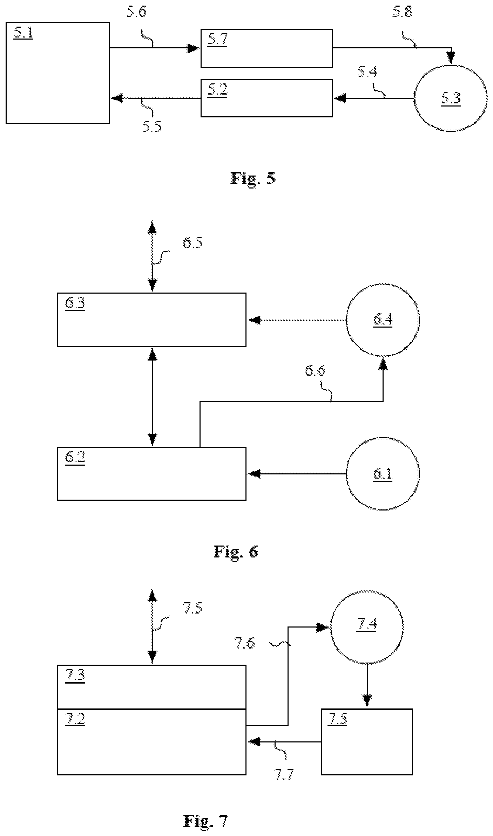

La Fig. 5 illustre quant à elle le fonctionnement de la synchronisation selon l'invention. Le but est ici de synchroniser la fréquence de l'oscillateur qui est utilisé par le sous-système radio. L'oscillateur 5.3 utilisé est un oscillateur pouvant être contrôlé, typiquement par une tension. La fréquence contrôlée 5.4 est émise vers le synthétiseur d'horloge 5.2 qui génère une horloge contrôlée 5.5. Cette horloge contrôlée est utilisée par le protocole de synchronisation temporelle 5.1 qui génère une valeur d'ajustement 5.6. Au lieu d'être utilisée directement par le synthétiseur pour ajuster l'horloge, cette valeur d'ajustement est utilisée par un module de contrôle de l'oscillateur 5.7 pour générer une valeur d'ajustement de la fréquence de l'oscillateur 5.8.

Le protocole de synchronisation temporelle échange des étiquettes temporelles entre le client et un ou plusieurs serveurs distants. Ces étiquettes temporelles sont utilisées pour calculer la compensation et la dérive en fréquence entre l'horloge locale et l'horloge distante de référence utilisée par les serveurs. Cette compensation et cette dérive sont utilisées pour produire des valeurs moyennes servant à ajuster l'heure et la fréquence de l'horloge locale.

La Fig. 6 illustre la génération des étiquettes temporelles dans le cas où une unité matérielle d'horodatage des paquets est utilisée. L'horloge locale que l'on cherche à synchroniser est l'horloge 6.4. Cette horloge sert à cadencer l'unité matérielle d'horodatage 6.3. Cette unité d'horodatage échange un flux de paquets 6.5 avec le ou les serveurs de référence. Elle place des étiquettes temporelles sur ces paquets. Les paquets reçus contiennent pour leur part l'étiquette temporelle de leur moment d'émission relatif à l'horloge de référence du serveur les ayant émis. Le protocole de gestion temporelle 6.2 fonctionne sur un processeur à part cadencé lui-même selon sa propre horloge de référence 6.1. Ce protocole de gestion temporelle 6.2 utilise ces étiquettes temporelles pour calculer la compensation et la dérive temporelle de l'horloge à synchroniser 6.4 et en déduit une valeur d'ajustement 6.6 pour la corriger. De telles unités d'horodatage matérielles sont relativement coûteuses.

La Fig. 7 illustre la gestion des étiquettes temporelles selon l'invention. L'unité d'horodatage 7.3 est logicielle et intégrée au logiciel s'exécutant sur le processeur général. Le protocole de gestion temporelle 7.2 est également exécuté sur ce même processeur dont l'horloge de référence 7.7 est dérivée de l'horloge à synchroniser 7.4 par un synthétiseur d'horloge 7.5. Le processeur est donc à même de générer des étiquettes temporelles basées sur l'horloge à synchroniser. Le traitement des étiquettes temporelles liées aux paquets 7.5 échangés avec le ou les serveurs correspond à celui fait précédemment et permet de générer la valeur d'ajustement 7.6. Avantageusement, l'unité d'horodatage est implémentée au niveau des pilotes du système d'exploitation opérant sur le processeur. Ceci permet d'assurer un traitement temps réel des paquets et de leur horodatage et permet d'obtenir des performances au niveau d'une implémentation matérielle. Conformément à la norme, les paquets sont horodatés juste après la réception du dernier bit pour un paquet reçu et juste avant l'émission du premier bit pour un paquet émis.

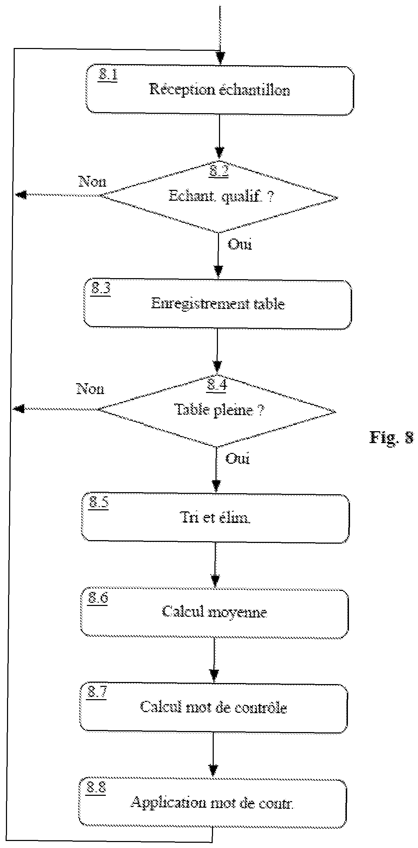

Le protocole de synchronisation temporelle utilisé, typiquement NTP, génère des échantillons de deux valeurs, une première valeur relative à la stabilité de l'horloge et une seconde relative à la dérive de fréquence. La stabilité de l'horloge fournie par NTP est la variation relative de fréquence de l'horloge locale calculée pour un échantillon donné par rapport à la valeur précédemment estimée de cette fréquence, elle exprime la capacité du système à maintenir une fréquence constante. La dérive en fréquence est l'estimation de variation de fréquence entre l'horloge locale et l'horloge de référence. L'algorithme de contrôle de l'oscillateur 3.10 doit générer une valeur de tension sous la forme d'un mot de 16 bits à partir des informations issues du protocole de synchronisation temporelle et donc des échantillons émis par celui-ci. Pour obtenir une bonne précision, il faut d'une part éliminer les échantillons aberrants et faire une moyenne. Les échantillons aberrants peuvent provenir d'incidents liés au transport des paquets sur le réseau de communication entre la passerelle et le ou les serveurs de référence. Le procédé utilisé dans l'exemple de réalisation pour générer cette valeur de tension pour contrôler l'oscillateur est décrit en relation avec la Fig. 8. Cet algorithme de contrôle de l'oscillateur traite les échantillons issus du protocole NTP utilisé par le protocole de synchronisation temporelle 3.9, il peut être adapté pour l'utilisation de PTP ou d'autres protocoles.

Lors d'une première étape 8.1, on réceptionne un échantillon comprenant donc une valeur de stabilité d'horloge et une valeur de dérive. Lors d'une étape 8.2, on vérifie si cet échantillon est qualifié ou non. Cette qualification consiste en un test de la valeur de stabilité pour éliminer les échantillons dont la stabilité est insuffisante, c'est-à-dire dont l'estimation de fréquence s'écarte trop sensiblement de l'estimation précédente. On enregistre alors les échantillons qualifiés dans une table lors de l'étape 8.3. On vérifie alors si cette table est pleine 8.4. Quand la table est pleine, on en trie les éléments en fonction de la valeur de dérive pour déterminer l'échantillon de plus petite dérive et l'échantillon de plus grande dérive, ces échantillons sont alors éliminés 8.5. On calcule la moyenne de la dérive sur les échantillons restants. Le mot de contrôle est alors calculé suivant la formule suivante :

$$C_n = C_o + \frac{D_m \cdot f_n \cdot a}{p} \; ;$$

Où:

$C_n$ représente la nouvelle valeur du mot de contrôle ;
$C_o$ représente l'ancienne valeur du mot de contrôle ;
$D_m$ représente la moyenne de la dérive obtenue à l'étape 8.6 en partie par million (ppm) ;
$f_n$ représente la fréquence nominale de l'oscillateur en Hz ;
$a$ représente un coefficient d'atténuation ;
$p$ représente la pente de la courbe donnant la fréquence en fonction de la tension, ou autrement dit l'écart en fréquence pour une différence de 1 dans le mot de contrôle. Son unité est en Hz par bit.

La pente de la courbe peut être donnée par le fabricant de l'oscillateur. Avantageusement cette pente est calculée lors d'une phase de calibration en usine.

Ce mot de contrôle doit alors être converti en un signal analogique devant être appliqué à l'oscillateur. Cette conversion doit être particulièrement précise et stable, notamment par rapport à la température ou par rapport à la variation d'alimentation, pour assurer la stabilité et la précision finale de la fréquence du système. Elle peut être réalisée par un convertisseur numérique analogique dédié. Avantageusement, elle peut utiliser, lorsqu'il existe, un convertisseur PWM (*Pulse Width Modulation* en anglais) présent sur le processeur central pour fournir le signal analogique après mise en forme et filtrage (circuit 3.14). Avantageusement le même procédé est utilisé pour le signal de contrôle du radiateur permettant la gestion de la température de l'oscillateur.

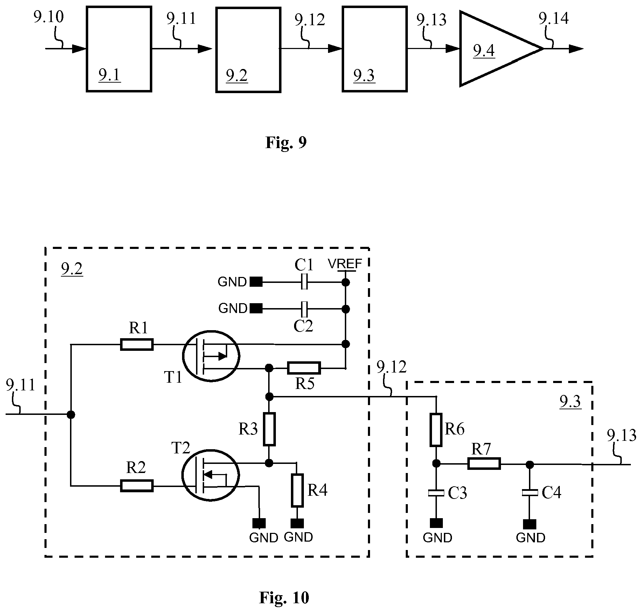

Lorsque le processeur central dispose d'un convertisseur PWM, il est possible de réduire le coût de la fonction de contrôle en tension de l'oscillateur et ainsi réduire le coût de la passerelle par rapport à l'utilisation d'un convertisseur numérique-analogique DAC (*Digital-to-Analog Converter* en anglais). Un tel mode de réalisation du circuit 3.14 est montré en Fig. 9 et est composé d'une porte logique 9.1, d'un calibrateur de tension 9.2 précis et stable en température et alimentation, d'un filtre passe-bas du second ordre 9.3 et d'un amplificateur opérationnel 9.4.

Le processeur central délivre un signal PWM 9.10 avec un niveau crête-à-crête qui n'est pas suffisamment stable en température et variation d'alimentation pour obtenir la précision et la stabilité de la tension de commande d'oscillateur souhaitée. Le mode de réalisation montré en Fig. 9 permet d'obtenir une précision et stabilité suffisantes pour assurer la précision finale de la fréquence de l'oscillateur.

La porte logique 9.1 est optionnelle et permet de réduire les temps de transition. Elle reçoit le signal PWM 9.10 fourni par le processeur central et fournit ainsi un signal PWM 9.12 au calibrateur de tension 9.2. Le calibrateur de tension 9.2 transforme le signal à modulation d'impulsion PWM, qui est précis en largeur d'impulsion, en un signal précis et stable en niveau de tension crête-à-crête, tout en gardant la précision et la stabilité en largeur d'impulsion. Un tel calibrateur 9.2 est par exemple aisément réalisé à l'aide de deux transistors à effet de champ MOSFET (*Metal-Oxide Semiconductor Field-Effect Transistor* en anglais) à enrichissement, l'un à canal N et l'autre à canal P.

Lorsque le calibrateur de tension 9.2 est réalisé à l'aide de deux transistors à effet de champ MOSFET, la porte logique 9.1 permet d'avoir une sortance plus grande que celle du processeur central, pour piloter les grilles des transistors à effet de champ MOSFET. Ceci permet d'obtenir des signaux avec des temps de transition plus faibles et plus stables.

Le signal 9.12 en sortie du calibrateur de tension 9.2 est transformé en tension continue 9.13 après passage à travers le filtre passe-bas du second ordre 9.3. Le filtre passe-bas du second ordre 9.3 est par exemple composé de deux cellules de type RC (Résistance-Capacité) et transforme le signal PWM 9.12 issu du calibrateur de tension 9.2 en tension continue. La fréquence de coupure du filtre passe-bas est faible devant la fréquence du signal PWM pour assurer un bruit résiduel négligeable sur la tension de commande de l'oscillateur. La fréquence de coupure du filtre passe-bas du second ordre 9.3 est en outre forte devant la fréquence de variation maximale de la commande de l'oscillateur pour que l'asservissement en fréquence fonctionne correctement.

Un exemple de réalisation du calibrateur de tension 9.2 et du filtre passe-bas du second ordre 9.3 est détaillé ci-après en relation avec la Fig. 10.

Enfin, l'amplificateur opérationnel 9.4 assure l'adaptation d'impédance entre la sortie du filtre passe-bas du second ordre 9.3 et l'entrée de l'oscillateur. On obtient ainsi en sortie de l'amplificateur opérationnel 9.4 une tension continue stable en température et en variation d'alimentation et avec la même précision en largeur d'impulsion que celle du signal PWM fourni par le processeur central.

L'amplificateur opérationnel 9.4 est monté en suiveur et réalise l'adaptation d'impédance entre la sortie du filtre passe-bas et l'entrée de l'oscillateur, l'amplificateur opérationnel 9.4 ayant une haute impédance d'entrée par rapport à l'impédance du filtre passe bas du second ordre 9.3 et une faible impédance de sortie par rapport à l'impédance d'entrée de l'oscillateur. On évite ainsi les variations de la tension de commande de l'oscillateur avec les variations en température de l'impédance d'entrée de l'oscillateur.

La Fig. 10 illustre schématiquement un mode de réalisation du calibrateur de tension 9.2 et du filtre passe-bas du second ordre 9.3.

Le calibrateur de tension 9.2 est principalement composé de deux transistors, T1 et T2, à effet de champ MOSFET, d'un jeu de trois résistances R3, R4 et R5, et des capacités réservoir C1 et C2. Le transistor T1 est à canal P, tandis que le transistor T2 est à canal N.

Le filtre passe-bas du second ordre 9.3 est composé des résistances R6 et R7 et des capacités C3 et C4.

Quand le niveau du signal d'entrée du calibrateur de tension 9.2 est à l'état bas :

- le transistor T2 est bloqué et présente une résistance série grande par rapport aux résistances R3, R4, R5 et R6 ;
- le transistor T1 est saturé et présente une résistance série faible par rapport aux résistances R3, R4, R5 et R6.

Dans ce cas, la tension en sortie du calibrateur de tension 9.2 est égale à VREF.

Inversement, quand le niveau du signal d'entrée du calibrateur de tension 9.2 est à l'état haut :

- le transistor T1 est bloqué et présente une résistance série grande par rapport aux résistances R3, R4, R5 et R6 ;
- le transistor T2 est saturé et présente une résistance série faible par rapport aux résistances R3, R4, R5 et R6.

Dans ce cas, la tension en sortie du calibrateur de tension 9.2 est égale à :

$$V = [(1+(X*(R5/R6)))/(1+(R5/R3)+(X*(R5/R6)))]*VREF.= A*VREF$$

avec X le rapport cyclique du signal PWM, compris entre 0 et 1.

On en déduit une tension crête-à-crête en sortie du calibrateur de tension 9.2 égale à (1-A)*VREF.

La tension VREF est définie en fonction de la plage de fonctionnement du contrôle de l'oscillateur, le paramètre principal étant la variation de la tension en fonction de la température, ce paramètre s'appliquant principalement pour les niveaux hauts en sortie des transistors T1 et T2.

Lors des transitions, où les deux transistors T1 et T2 sont saturés en même temps, le courant débité par la référence de tension est limité à VREF / R3. Les capacités réservoir C1 et C2 permettent de fournir l'appel de courant liés à ces transitions.

Un paramètre qui fait varier la tension de commande de l'oscillateur est la variation en température du courant de fuite du transistor T1, quand les niveaux de sortie des transistors T1 et T2 sont à l'état bas. L'influence du courant de fuite du transistor T2 est négligeable.

Un autre paramètre qui fait varier la tension de commande de l'oscillateur est la variation du temps de propagation des transitions du signal 9.11 via les transistors T1 et T2, en fonction de la température. Ces transitions n'étant pas de durée nulle, les variations de la tension de seuil en fonction de la température provoquent des variations de ce temps de propagation.

Un autre paramètre qui fait varier la tension de commande de l'oscillateur est la résistance minimale du canal drain-source RDS(on) du transistor T2, ce paramètre s'appliquant pour les niveaux bas en sortie des transistors T1 et T2.

Un autre paramètre qui fait varier la tension de commande de l'oscillateur est la résistance minimale du canal drain-source RDS(on) du transistor T1, ce paramètre s'appliquant pour les niveaux hauts en sortie des transistors T1 et T2.

Il est à noter que, les transistors T1 et T2 étant de type MOSFET, leurs capacités d'entrée varient très peu avec la température, ce qui provoque une variation négligeable de la tension de commande de l'oscillateur.

Un autre paramètre qui fait varier la tension de commande de l'oscillateur est la variation en température des résistances R3 et R5, quand les niveaux de sortie des transistors T1 et T2 sont à l'état bas.

Il est à noter que les contributions des paramètres cités ci-dessus dans les variations de la tension de commande de l'oscillateur ne s'ajoutent pas directement et on tendance à s'équilibrer, puisqu'elles interviennent de manière répartie sur les niveaux hauts ou bas.

Ainsi, il est possible de choisir des composants standards, à faible coût, pour réaliser la fonction de contrôle de l'oscillateur, en tenant compte de ces contraintes liées aux variations de la tension de commande de l'oscillateur.

La linéarité du mode de réalisation présenté en Fig. 10 est principalement donnée par la gigue du signal PWM 9.10, celle-ci étant liée à celle du signal d'horloge pilotant le processeur central, ainsi qu'à la différence entre fronts de montée et de descente à la sortie du calibrateur de tension 9.2, à la linéarité de l'amplificateur opérationnel 9.4, ainsi qu'à la résistance R6 d'entrée du filtre passe-bas de second ordre 9.3, la résistance R3 devant être négligeable par rapport à la résistance R6.

Les caractéristiques du contrôle en fréquence des oscillateurs peuvent varier d'un échantillon à un autre. Avantageusement, une calibration en usine de chaque oscillateur est effectuée. Cette calibration permet de stocker un ensemble de couples de valeurs établissant la correspondance entre un mot de contrôle et la fréquence associée obtenue. Le dispositif est alors doté de moyens de stockage d'une table contenant ces couples de valeurs. Ceux-ci sont alors utilisés par le protocole de gestion temporelle et par l'algorithme de contrôle de la fréquence. Si la courbe établissant la correspondance entre la tension et la fréquence est linéaire, deux points suffisent à établir la fréquence nominale et la pente de la courbe.

L'invention ici décrite permet de concevoir tout type d'appareils connectés d'une part à un réseau de communication de données par paquets et d'autre part ayant un sous-système de radio communication basé sur un système de génération d'horloge unique servant de référence et au sous système radio et au processeur général de gestion de l'appareil.

**Revendications**

1. Dispositif de communication comprenant :

  - une interface (3.1) de communication avec un réseau de communication par paquet ;
  - un processeur général (3.3) ;
  - un sous système de radio communication ;
  - un oscillateur (3.15) pour la génération du signal d'horloge de référence du sous-système de radio communication ;

  **caractérisé en ce qu'**il comporte en outre :

  - des moyens de synchronisation (3.12), mis en oeuvre par le processeur général, pour synchroniser le signal d'horloge de référence du sous-système de radio communication avec au moins une source de référence distante au travers du réseau de communication par paquets ;
  - des moyens (3.16) pour générer l'horloge de référence du processeur général et l'horloge de référence du sous-système radio à partir du seul et même oscillateur.

**2.** Dispositif de communication selon la revendication 1, **caractérisé en ce que** les moyens de synchronisation comprennent des moyens logiciels d'horodatage (3.4) de paquets de données échangés entre le dispositif et la source de référence distante exécutés par le processeur général.

**3.** Dispositif de communication selon la revendication 2, **caractérisé en ce que** les moyens de synchronisation comprennent des moyens logiciels de contrôle (3.9, 3.10) de la fréquence de l'oscillateur.

**4.** Dispositif de communication selon l'une des revendications 1 à 3, **caractérisé en ce qu'**il comprend en outre des moyens logiciels pour maintenir l'oscillateur (3.15) à température constante à l'aide d'un radiateur (3.13).

**5.** Dispositif de communication selon la revendication 3, **caractérisé en ce que** les moyens logiciels de contrôle de la fréquence de l'oscillateur comprennent des moyens pour mettre en oeuvre :

- un protocole de synchronisation temporelle (3.9) qui génère des échantillons de deux valeurs, une première relative à la stabilité de l'horloge et une seconde relative à la dérive de fréquence ;
- un algorithme de contrôle de l'oscillateur (3.10) pour générer une valeur de tension à partir des échantillons issus du protocole de synchronisation temporelle (3.9).

**6.** Dispositif de communication selon la revendication 5, **caractérisé en ce que** le processeur central disposant d'un convertisseur PWM, l'algorithme de contrôle de l'oscillateur (3.10) dispose de moyens de génération d'un signal PWM à l'aide de ce convertisseur à partir de la valeur de tension ;
le dispositif comprenant en outre un circuit (3.14) qui convertit ce signal PWM en un signal de tension appliqué à l'oscillateur mis en forme et filtré avec une précision et stabilité suffisantes pour assurer la précision finale de la fréquence du système.

**7.** Dispositif de communication selon la revendication 6, **caractérisé en ce que** ledit circuit est composé :

- d'un calibrateur de tension (9.2) recevant le signal PWM ;
- d'un filtre passe-bas du second ordre (9.3) filtrant la sortie du calibrateur de tension (9.2);
- d'un amplificateur opérationnel (9,4) monté en suiveur et intercalé entre la sortie du filtre passe-bas du second ordre (9.3) et ledit oscillateur.

**8.** Dispositif de communication selon la revendication 7, **caractérisé en ce qu'**une porte logique (9.1) est intercalée entre le convertisseur PWM et le calibrateur de tension (9.2), et est adaptée pour réduire les temps de transition du signal PWM.

**9.** Dispositif de communication selon la revendication 5, **caractérisé en ce que** l'algorithme de contrôle de l'oscillateur comprend :

- des moyens de réception des échantillons issus du protocole de synchronisation ;
- des moyens de qualification pour éliminer les échantillons dont la stabilité est insuffisante ;
- des moyens de tri pour trier les échantillons qualifiés par leur valeur de dérive et éliminer les échantillons de plus petite et plus grande dérive ;
- des moyens de calcul de la moyenne de la dérive des échantillons restants ;
- des moyens de calcul de la valeur de tension à partir de la moyenne.

**10.** Procédé de contrôle d'un oscillateur (3.15), le procédé étant mis en oeuvre dans un dispositif de communication comportant ledit oscillateur, un processeur général et un sous-système de radio communication, ledit oscillateur générant le signal d'horloge de référence du sous-système de radio communication, le signal d'horloge de référence du sous-système de radio communication étant synchronisé avec au moins une source de référence distante au travers d'un réseau de communication par paquets,
**caractérisé en ce que**, l'horloge de référence du processeur général et l'horloge de référence du sous-système radio étant générées à partir du seul même oscillateur, le procédé comporte, mis en oeuvre sous forme logicielle par le processeur général :

- un protocole de synchronisation temporelle (3.9) qui génère des échantillons de deux valeurs, une première relative à une stabilité d'horloge et une seconde relative à une dérive de fréquence ;
- un algorithme de contrôle de l'oscillateur (3.10) pour générer une valeur de tension à partir des échantillons issus du protocole de synchronisation temporelle (3.9) ;

et **en ce que** l'algorithme de contrôle de l'oscillateur comprend :

- une étape (8.1) de réception des échantillons issus du protocole de synchronisation temporelle ;
- une étape (8.2) de qualification pour éliminer les échantillons dont la stabilité est insuffisante ;
- une étape (8.5) de tri pour trier les échantillons qualifiés par leur valeur de dérive et éliminer les échantillons de plus petite et plus grande dérive ;
- une étape (8.6) de calcul de la moyenne de la dérive des échantillons restants ;
- une étape (8.7) de calcul de la valeur de tension à partir de la moyenne.


**Patentansprüche**

1.  Kommunikationsvorrichtung, welche umfasst:

    - eine Schnittstelle (3.1) zur Kommunikation mit einem Paketkommunikationsnetz;
    - einen Universalprozessor (3.3);
    - ein Funkkommunikations-Teilsystem;
    - einen Oszillator (3.15) zur Erzeugung des Referenztaktsignals des Funkkommunikations- Teilsystems;

    **dadurch gekennzeichnet, dass** sie außerdem umfasst:

    - Synchronisationsmittel (3.12), die von dem Universalprozessor eingesetzt werden, um das Referenztaktsignal des Funkkommunikations-Teilsystems über das Paketkommunikationsnetz mit wenigstens einer entfernten Referenzquelle zu synchronisieren;
    - Mittel (3.16) zum Erzeugen des Referenztakts des Universalprozessors und des Referenztakts des Funkteilsystems aus dem einen einzigen Oszillator.

2.  Kommunikationsvorrichtung nach Anspruch 1, **dadurch gekennzeichnet, dass** die Synchronisationsmittel von dem Universalprozessor ausgeführte Softwaremittel zur Zeitstempelung (3.4) von Datenpaketen umfassen, die zwischen der Vorrichtung und der entfernten Referenzquelle ausgetauscht werden.

3.  Kommunikationsvorrichtung nach Anspruch 2, **dadurch gekennzeichnet, dass** die Synchronisationsmittel Softwaremittel zur Regelung (3.9, 3.10) der Frequenz des Oszillators umfassen.

4.  Kommunikationsvorrichtung nach einem der Ansprüche 1 bis 3, **dadurch gekennzeichnet, dass** sie außerdem Softwaremittel zum Aufrechterhalten einer konstanten Temperatur des Oszillators (3.15) mithilfe eines Heizkörpers (3.13) umfasst.

5.  Kommunikationsvorrichtung nach Anspruch 3, **dadurch gekennzeichnet, dass** die Softwaremittel zur Regelung der Frequenz des Oszillators Mittel umfassen, um auszuführen:

    - ein Zeitsynchronisationsprotokoll (3.9), welches Stichproben mit zwei Werten erzeugt, wobei ein erster sich auf die Stabilität des Taktes bezieht und ein zweiter sich auf die Frequenzabweichung bezieht;
    - einen Algorithmus zur Regelung des Oszillators (3.10), um aus den von dem Zeitsynchronisationsprotokoll (3.9) stammenden Stichproben einen Spannungswert zu erzeugen.

6.  Kommunikationsvorrichtung nach Anspruch 5, **dadurch gekennzeichnet, dass** der Universalprozessor über einen PWM-Wandler verfügt und der Algorithmus zur Regelung des Oszillators (3.10) über Mittel zur Erzeugung eines PWM-Signals mithilfe dieses Wandlers aus dem Spannungswert verfügt;
    wobei die Vorrichtung außerdem eine Schaltung (3.14) umfasst, welche dieses PWM-Signal in ein an den Oszillator angelegtes Spannungssignal umwandelt, das mit einer Genauigkeit und Stabilität geformt und gefiltert wird, die ausreichend sind, um die Endgenauigkeit der Frequenz des Systems sicherzustellen.

7.  Kommunikationsvorrichtung nach Anspruch 6, **dadurch gekennzeichnet, dass** die Schaltung besteht:

    - aus einem Spannungskalibrator (9.2), der das PWM-Signal empfängt;

- aus einem Tiefpassfilter zweiter Ordnung (9.3), das den Ausgang des Spannungskalibrators (9.2) filtert;
- aus einem Operationsverstärker (9.4), der als Spannungsfolger geschaltet ist und zwischen den Ausgang des Tiefpassfilters zweiter Ordnung (9.3) und den Oszillator geschaltet ist.

8. Kommunikationsvorrichtung nach Anspruch 7, **dadurch gekennzeichnet, dass** ein Logikgatter (9.1) zwischen den PWM-Wandler und den Spannungskalibrator (9.2) geschaltet ist und dafür ausgelegt ist, die Übergangszeit des PWM-Signals zu verringern.

9. Kommunikationsvorrichtung nach Anspruch 5, **dadurch gekennzeichnet, dass** der Algorithmus zur Regelung des Oszillators umfasst:

   - Mittel zum Empfang der von dem Synchronisationsprotokoll stammenden Stichproben;
   - Qualifizierungsmittel, um die Stichproben zu entfernen, deren Stabilität nicht ausreichend ist;
   - Sortiermittel zum Sortieren der qualifizierten Stichproben nach ihrem Abweichungswert und Entfernen der Stichproben mit der kleinsten und der größten Abweichung;
   - Mittel zur Berechnung des Mittelwertes der Abweichung der verbleibenden Stichproben;
   - Mittel zur Berechnung des Spannungswertes aus dem Mittelwert.

10. Verfahren zur Regelung eines Oszillators (3.15), wobei das Verfahren in einer Kommunikationsvorrichtung durchgeführt wird, welche den Oszillator, einen Universalprozessor und ein Funkkommunikations-Teilsystem aufweist, wobei der Oszillator das Referenztaktsignal des Funkkommunikations-Teilsystems erzeugt, wobei das Referenztaktsignal des Funkkommunikations-Teilsystems über ein Paketkommunikationsnetz mit wenigstens einer entfernten Referenzquelle synchronisiert wird,
    **dadurch gekennzeichnet, dass**, wenn der Referenztakt des Universalprozessors und der Referenztakt des Funkteilsystems aus dem einen einzigen Oszillator erzeugt werden, das Verfahren Folgendes, das in Form von Software durch den Universalprozessor ausgeführt wird, umfasst:

    - ein Zeitsynchronisationsprotokoll (3.9), welches Stichproben mit zwei Werten erzeugt, wobei ein erster sich auf die Taktstabilität bezieht und ein zweiter sich auf eine Frequenzabweichung bezieht;
    - einen Algorithmus zur Regelung des Oszillators (3.10), um aus den von dem Zeitsynchronisationsprotokoll (3.9) stammenden Stichproben einen Spannungswert zu erzeugen;

    und dadurch, dass der Algorithmus zur Regelung des Oszillators umfasst:

    - einen Schritt (8.1) des Empfangs der von dem Zeitsynchronisationsprotokoll stammenden Stichproben;
    - einen Schritt (8.2) der Qualifizierung zum Entfernen der Stichproben, deren Stabilität nicht ausreichend ist;
    - einen Schritt (8.5) der Sortierung zum Sortieren der qualifizierten Stichproben nach ihrem Abweichungswert und Entfernen der Stichproben mit der kleinsten und der größten Abweichung;
    - einen Schritt (8.6) der Berechnung des Mittelwertes der Abweichung der verbleibenden Stichproben;
    - einen Schritt (8.7) der Berechnung des Spannungswertes aus dem Mittelwert.

**Claims**

1. Communication device comprising:

   - an interface (3.1) for communicating with a packet communication network;
   - a general processor (3.3);
   - a radio communication subsystem;
   - an oscillator (3.15) for generating reference clock signal of the radio communication subsystem;

   **characterised in that** it further comprises:

   - synchronisation means (3.12), implemented by the general processor, for synchronising the reference clock signal of the radio communication subsystem with at least one distant reference source over the packet communication network;
   - means (3.16) for generating the reference clock of the general processor and the reference clock of the radio subsystem from the single and same oscillator.

**2.** Communication device according to claim 1, **characterised in that** the synchronisation means comprise software means for timestamping (3.4) data packets exchanged between the device and the distant reference source executed by the general processor.

**3.** Communication device according to claim 2, **characterised in that** the synchronisation means comprise software means for controlling (3.9, 3.10) the frequency of the oscillator.

**4.** Communication device according to claim 1, **characterised in that** it further comprises software means for maintaining the oscillator at constant temperature by way of a radiator (3.13).

**5.** Communication device according to claim 3, **characterised in that** the software means for controlling the frequency of the oscillator (3.15) comprise means for implementing:

- a time synchronisation protocol (3.9) that generates samples with two values, a first one relating to stability of the clock and a second relating to frequency drift;
- an algorithm for controlling the oscillator (3.10) for generating a voltage value from the samples issuing from the time synchronisation protocol (3.9).

**6.** Communication device according to claim 5, **characterised in that**, the central processing having a PWM converter, the algorithm for controlling the oscillator (3.10) has means for generating a PWM signal by way of this converter from the voltage value;

the device further comprising a circuit (3.14) that converts the PWM signal into a voltage signal applied to the oscillator shaped and filtered with sufficient accuracy and stability to ensure final accuracy of the frequency of the system.

**7.** Communication device according to claim 6, **characterised in that** the said circuit is composed of:

- a voltage calibrator (9.2) receiving the PWM signal;
- a second-order low-pass filter (9.3) filtering the voltage calibrator output (9.2);
- an operational amplifier (9.4) connected as a follower and interposed between the output of the second-order low-pass filter (9.3) and said oscillator.

**8.** Communication device according to claim 7, **characterised in that** a logic gate (9.1) is interposed between the PWM converter and the voltage calibrator (9.2), and is adapted to reduce the PWM signal transition times.

**9.** Communication device according to claim 5, **characterised in that** the algorithm for controlling the oscillator comprises:

- means for receiving samples issuing from the synchronisation protocol;
- qualification means for eliminating the samples having insufficient stability;
- sorting means for sorting the qualified samples by their drift value and eliminating the samples with the smallest and greatest drift;
- means for calculating the average of the drift of the remaining samples;
- means for calculating the voltage value from the average.

**10.** Method of controlling an oscillator, the method being implemented in a communication device comprising said oscillator, a general processor and a radio communication subsystem, said oscillator generating the reference clock signal of the radio communication subsystem, the reference clock signal of the radio communication subsystem being synchronised with at least one distant reference source over a packet communication network,

**characterised in that**, the reference clock of the general processor and the reference clock of the radio subsystem being generated from a single and same oscillator, the method comprises, implemented in software form by the general processor:

- a time synchronisation protocol (3.9) that generates samples with two values, a first one relating to clock stability and a second one relating to frequency drift;
- an algorithm for controlling the oscillator (3.10) for generating a voltage value from the samples issuing from the time synchronisation protocol (3.9);

and **in that** the algorithm for controlling oscillator comprises:

- a step (8.1) of receiving the samples issuing from the time synchronisation protocol;
- a qualification step (8.2) for eliminating the samples with insufficient stability;
- a sorting step (8.5) for sorting the qualified samples by their drift value and eliminating the samples with the smallest and greatest drift;
- a step (8.6) of calculating the average of the drift of the remaining samples;
- a step (8.7) of calculating the voltage value from the average.

Fig. 1

1.2

1.4

1.3

1.5

1.6

1.1

2.1

2.2

Fig. 2

2.3

2.6

2.7

2.8

2.11

2.12

2.10

2.4

2.9

2.13

2.5

Fig. 3

Fig. 4

Fig. 5

Fig. 6

Fig. 7

**8.1** Réception échantillon

**8.2** Echant. qualif. ? — Non

Oui

**8.3** Enregistrement table

**8.4** Table pleine ? — Non

Oui

**8.5** Tri et élim.

**8.6** Calcul moyenne

**8.7** Calcul mot de contrôle

**8.8** Application mot de contr.

Fig. 8

**Fig. 9**

**Fig. 10**

**EP 2 489 142 B1**

## RÉFÉRENCES CITÉES DANS LA DESCRIPTION

### Documents brevets cités dans la description

- EP 1835616 A

- US 6898721 B, Schmidt